# EUROPÄISCHE PATENTSCHRIFT

(11) **EP 1 386 335 B1**
(45) Veröffentlichungstag und Bekanntmachung des Hinweises auf die Patenterteilung: **10.03.2010**
(21) Anmeldenummer: 02740247.8
(22) Anmeldetag: 11.04.2002
(51) Int. Cl.: H01G 4/30

(54) **ELEKTRISCHES VIELSCHICHTBAUELEMENT UND VERFAHREN ZU DESSEN HERSTELLUNG**
ELECTRICAL MULTILAYER COMPONENT AND METHOD FOR THE PRODUCTION THEREOF
COMPOSANT ELECTRIQUE MULTICOUCHE ET SON PROCEDE DE PRODUCTION

(30) Priorität: 26.04.2001 DE 10120517
(43) Veröffentlichungstag der Anmeldung: 04.02.2004
(73) Patentinhaber: EPCOS AG, 81669 München (DE)
(72) Erfinder: KIRSTEN, Lutz, A-8530 Deutschlandsberg (AT)
(74) Vertreter: Epping - Hermann - Fischer
(86) Internationale Anmeldenummer: PCT/DE2002/001360
(87) Internationale Veröffentlichungsnummer: WO 2002/089160

(56) Entgegenhaltungen:
- EP-A- 0 514 149
- EP-A- 1 022 769
- DE-A- 19 719 174
- US-A- 4 831 432
- US-A- 6 159 267

## Beschreibung

Die Erfindung betrifft ein elektrisches Vielschichtbauelement mit einem Schichtstapel mit übereinanderliegenden Dielektrikumschichten, welche ein keramisches Material umfassen, und mit dazwischenliegenden, elektrisch leitfähigen Elektrodenschichten. Darüber hinaus betrifft die Erfindung ein Verfahren zur Herstellung des Vielschichtbauelements.

Aus der Druckschrift DE 197 19 174 A1 ist ein Bauelement der eingangs genannten Art bekannt, bei dem der elektrische Widerstand der Dielektrikumschichten einen positiven Temperaturkoeffizienten aufweist, und bei dem die Elektrodenschichten aus Aluminium hergestellt sind. Zur Herstellung eines solchen Vielschicht-Kaltleiters ist die Verwendung von unedlen Metallen als Elektrodenschicht notwendig, da nur solche Metalle eine für die Funktion in einem PTC-Element notwendige Oxidschicht an ihrer Oberfläche ausbilden, welche zum Sperrschichtabbau zwischen Elektrodenschicht und Dielektrikumschicht benötigt wird.

Das bekannte Bauelement hat den Nachteil, daß das verwendete Aluminium bei den für Kaltleiter-Keramiken typischen Sintertemperaturen >1300°C nicht stabil ist und oxidiert. Die Elektrodenschichten weisen daher nach dem Sintern einen hohen Ohmschen Widerstand auf, welcher für einen Vielschicht-Kaltleiter unerwünscht ist.

Ferner hat das bekannte PTC-Bauelement den Nachteil, daß das Aluminium bei den hohen Sintertemperaturen von > 1000 °C leicht in die Keramik eindiffundiert und die gewünschten Eigenschaften der PTC-Keramik beeinträchtigt.

Des weiteren sind aus der Druckschrift DE 199 16 380 A1 Bauelemente der eingangs genannten Art bekannt, bei denen die Dielektrikumschichten aus einem piezoelektrischen Material ausgewählt sind. Die Elektrodenschichten sind aus einer Mischung von Silber und Palladium gefertigt.

Die US 4,831,432 offenbart ein Halbleiter-Bauelement, das auf Basis einer PTC-Keramik hergestellt ist und als Elektroden Nickelschichten aufweist, die eine Silber- bzw. Silber/Palladium-Schutzschicht aufweisen. Um eine Silber-Migration zu verhindern, werden u.a. mit einer Silber/Palladium-Schicht beschichtete Silberpartikel eingesetzt.

Diese bekannten Bauelemente haben den Nachteil, daß die Materialien Silber und Palladium teuer in der Beschaffung sind. Leichter und billiger verfügbare Materialien, wie beispielsweise Kupfer, erfordern einen sehr hohen prozeßtechnischen Aufwand, um Kupfer nicht zu oxidieren.

Ziel der vorliegenden Erfindung ist es daher, ein elektrisches Vielschichtbauelement anzugeben, das es erlaubt, ein in den Elektrodenschichten verwendetes Metall vor Oxidation in sauerstoffhaltiger Atmosphäre bei hohen Temperaturen zu schützen.

Dieses Ziel wird erfindungsgemäß durch ein Vielschichtbauelement nach Patentanspruch 1 erreicht. Weitere Ausgestaltungen der Erfindung und ein Verfahren zur Herstellung der Erfindung sind den weiteren Ansprüchen zu entnehmen.

Die Erfindung gibt ein elektrisches Vielschichtbauelement an, das einen Schichtstapel mit übereinanderliegenden Dielektrikumschichten umfaßt. Die Dielektrikumschichten enthalten ein keramisches Material und sind durch zwischen den Dielektrikumschichten angeordnete, elektrisch leitfähige Elektrodenschichten voneinander getrennt. Wenigstens eine Elektrodenschicht enthält einen von einer Schutzschicht umhüllten als Partikel ausgebildeten Körper aus unedlem Metall. Die Schutzschicht hat die Aufgabe, die Oxidation des Körpers zu verhindern bzw. zu verlangsamen. Als Schutzschicht kommen Metalle in Frage, die ein größeres Standard-Elektrodenpotential aufweisen als das Metall im Körper, insbesondere Edelmetalle. Die Schutzschicht kann aber auch jede andere geeignete Verbindung darstellen, wie z.B. bor- oder siliziumhaltige Gläser.

Als erfindungsgemäße Vielschichtbauelemente kommen insbesondere Kondensatoren, Heißleiter, Varistoren und piezoelektrische Bauelemente in Betracht.

Das erfindungsgemäße Vielschichtbauelement hat den Vorteil, daß die Schutzschicht aufgrund des in ihr enthaltenen Schutzmaterials den Körper vor ungewollter Oxidation schützt. Insbesondere ermöglicht die Erfindung die Verwendung von unedlen Metallen als Metall für den Körper. Die unedlen Metalle haben den Vorteil, daß sie billig und leicht verfügbar sind. Unter unedlen Metallen sind alle Metalle zu verstehen, deren Standard-Elektrodenpotential gemessen gegen eine Standardwasserstoffelektrode bei 25°C negativ ist.

Darüber hinaus erlaubt das erfindungsgemäße Bauelement die Anwendung von Prozeßschritten, bei denen das Bauelement während oder nach der Herstellung einer Sauerstoffatmosphäre ausgesetzt ist. Aufgrund der Schutzschicht kann gegenüber einem Vielschichtbauelement ohne Schutzschicht entweder ein höherer Sauerstoffpartialdruck oder eine höhere Temperatur oder auch beides auf das Bauelement angewendet werden, ohne daß die Elektrodenschichten vollständig oxidiert werden. Dies ist insbesondere von Vorteil, wenn das Vielschichtbauelement durch einen Sinterprozeß hergestellt wird. Bei Verwendung von unedlen Metallen in Elektrodenschichten muß beim Sintern üblicherweise sehr genau auf einen gegenüber Luft verringerten Sauerstoffpartialdruck geachtet werden. Mit dem erfindungsgemäßen Bauelement ist es nun möglich, eine Sinterung bei relativ hohem Sauerstoffpartialdruck durchzuführen. Dadurch können Prozesse vereinfacht und Prozeßkosten eingespart werden.

Das erfindungsgemäße Bauelement kann besonders vorteilhaft durch Gemeinsamsinterung von keramischen Grünfolien und elektrisch leitenden Schichten hergestellt sein. Dadurch wird es in einem einfach durchzuführenden Prozeß ermöglicht, viele Schichten übereinander zu stapeln und in einem einzigen Schritt zu einem monolithischen Bauelement zu verbinden. Insbesondere erlaubt die Gemeinsamsinterung von keramischen Grünfolien mit Elektrodenschichten das Herstellen von Bauelementen mit sehr vielen Elektrodenschichten, was beispielsweise bei Kondensatoren für eine hohe Kapazität, bei Vielschicht-Kaltleitern für einen niedrigen Widerstand und bei piezoelektrischen Bauelementen für eine hohe mechanische Auslenkung genutzt werden kann.

Darüber hinaus können an den Außenflächen des erfindungsgemäßen Bauelements in einer vorteilhaften Ausführungsform Außenelektroden angeordnet sein, die mit den Elektrodenschichten kontaktiert sind. Dadurch ist es möglich, Vielschichtbauelemente herzustellen, die für die Oberflächenmontagetechnik geeignet sind. Geeignete Außenelektroden wären beispielsweise kappenartig an zwei gegenüberliegenden Seitenflächen des Schichtstapels angeordnete Elektroden, welche ohne weiteres mit den Leiterbahnen einer Leiterplatte in einer Oberflächenmontagetechnik verlötet werden können.

Eine weitere vorteilhafte Ausführungsform der Erfindung besteht darin, benachbarte Elektrodenschichten mit verschiedenen Außenelektroden zu kontaktieren. Dadurch wird es möglich, die Elektrodenschichten in Form von ineinandergreifenden Kammstrukturen anzuordnen. Dadurch kann insbesondere bei Kondensatoren eine hohe Kapazität durch Parallelschalten verschiedener Teilkapazitäten, bei Vielschicht-Kaltleitern ein reduzierter Grundwiderstand durch Parallelschalten mehrerer Teilwiderstände und bei piezoelektrischen Bauelementen eine erhöhte mechanische Auslenkung erreicht werden.

Um den Anforderungen bestimmter Sinterprozesse bei Temperaturen >800°C zu genügen ist es vorteilhaft, das Schutzmaterial so auszuwählen, daß es auch bei Sintertemperaturen >800°C die Oxidation des Körpers verlangsamt. Dadurch wird es möglich, keramische Vielschichtbauelemente mit unedlen Metallen in den Elektrodenschichten zu realisieren, die ohne Schutzschicht bei den oben genannten Sintertemperaturen oxidiert würden. Solche keramischen Bauelemente sind beispielsweise Piezoaktoren oder auch Vielschicht-Kaltleiter.

Während für das Metall des Körpers unedle Metalle in Betracht kommen, werden für das Schutzmaterial vorzugsweise Edelmetalle verwendet, die die o.g. Temperaturstabilität bei Sinterung an Luft aufweisen. Insbesondere kommen als Edelmetalle für das Schutzmaterial Silber, Gold, Platin oder auch Palladium in Betracht. Aber auch andere Materialien, wie z.B. bor- oder siliziumhaltige Verbindungen sind möglich.

Für den Körper geeignete Metalle sind beispielsweise Wolfram, Kupfer, Nickel, Chrom, Aluminium oder Titan. Das Metall Wolfram ist beispielsweise auch als Zusatz geeignet zur Herstellung von Vielschicht-Kaltleitern. Dies gilt ebenso für Chrom und Zink. Kupfer ist insbesondere für die Herstellung von Piezoaktoren geeignet, während das Metall Nickel zusammen mit einer erfindungsgemäßen Schutzschicht vorteilhafterweise bei Kondensatoren eingesetzt wird, wodurch die Prozeßführung wegen der dadurch möglichen Sinterung an Luft anstelle von Sinterung bei reduziertem Sauerstoffgehalt vereinfacht werden kann.

Zur Realisierung eines keramischen Vielschicht-Kaltleiters ist es besonders vorteilhaft, wenn der Ohmsche Widerstand der Dielektrikumschichten einen positiven Temperaturkoeffizienten aufweist. Dies ist beispielsweise möglich durch von Verwendung von Kaltleiter-Keramiken. Eine geeignete Kaltleiter-Keramik ist beispielsweise eine Bariumtitanat-Keramik der allgemeinen Zusammensetzung (Ba, Ca, Sr, Pb) TiO₃ die mit Donatoren und/oder Akzeptoren, beispielsweise mit Mangan und Yttrium dotiert ist.

Bei Verwendung einer solchen Keramik werden zum Sperrschichtabbau bevorzugt Zusätze von unedlen Metalle wie Aluminium, Chrom oder Zink in den Elektrodenschichten verwendet. Es ist aber auch insbesondere Wolfram als Metall für die Elektrodenschicht geeignet. Unter Sperrschichtabbau ist dabei zu verstehen, daß unedle Metalle an der Grenzschicht Elektrode/Keramik oxidiert werden und die Ladungsträgerkonzentration in einer Randschicht zwischen Elektrodenschicht und Dielektrikumschicht dadurch erhöht wird (Anreicherungs-Randschicht). Dadurch wird ein Ohmscher Kontakt aufgebaut, der für die Funktion eines Vielschicht-Kaltleiters notwendig ist. Die genannten Metalle würden jedoch ohne Schutzschicht bei einer Sinterung an Luft, wie sie für die einfache Realisierung von Vielschichtbauelementen notwendig ist, bei den für Kaltleiter-Keramiken typischen Sintertemperaturen vollständig oxidiert. Damit würden die Elektrodenschichten und die Keramik unbrauchbar, weil die oxidierten Elektrodenbestandteile aus der Grenzschicht Elektrode/Keramik in die Keramik diffundieren. Die Sinterung in einer sauerstoffhaltigen Atmosphäre ist notwendig, um die korngrenzenaktiven Schichten der Kaltleiter-Keramik beim Abkühlen nach dem Sintern aufzubauen. Mit Hilfe der Schutzschicht können aber die notwendigen Sinterbedingungen eingehalten werden, ohne die Elektrodenschichten oder Zusätze zur Elektrode vollständig zu oxidieren.

Vielschicht-Kaltleiter werden zum Zwecke der Sicherung von Komponenten oder Modulen vor hohen Strömen verwendet. Bei einem plötzlich ansteigenden Strom wächst der Widerstand der Vielschicht-Kaltleiter sehr stark an, wodurch eine seriell zum Vielschicht-Kaltleiter geschaltete Komponente oder Schaltung vor Überströmen wirksam geschützt werden kann. Nach Beseitigung des Fehlerzustands, aus dem der hohe Strom resultiert, kühlt der Vielschicht-Kaltleiter ab und erreicht wieder einen niedrigen ohmschen Widerstand. Keramische Vielschicht-Kaltleiter haben aufgrund der Parallelschaltung einer Vielzahl von Einzelwiderständen den Vorteil, daß sie einen sehr niedrigen Bauteilwiderstand bei niedrigen Temperaturen aufweisen, den sie zuverlässig auch nach mehrmaligem Ansteigen und Abfallen des durch den Kaltleiter fließenden Stromes immer wieder erreichen.

Bei der Ausführung des erfindungsgemäßen Bauelements als Vielschicht-Kaltleiter kommen insbesondere auch Materialien für den Körper in Betracht, die chemische Verbindungen von Wolfram darstellen. Insbesondere kommen in Betracht Wolframkarbid oder auch Wolframnitrid. Solche Wolfram-Mischungen bzw. -Verbindungen haben den Vorteil, daß die Oxidation von Wolfram gehemmt aber nicht ganz verhindert wird, so daß der notwendige Sperrschichtabbau nach wie vor stattfinden kann und trotzdem eine hohe Leitfähigkeit innerhalb der Elektrodenschicht gewährleistet ist.

Erfindungsgemäß können die in den Elektrodenschichten angeordneten Körper von einer Schutzschicht umhüllte Partikel sein. Dies ermöglicht die Verwendung von Pulvern, die eine Vielzahl von solchen Partikeln enthalten, zur Herstellung der Elektrodenschichten, wodurch die Anwendung der bekannten Siebdruckverfahren ermöglicht wird. Daraus resultiert der Vorteil, daß für das Aufbringen der Elektrodenschichten auf den keramischen Grünfolien bzw. deren weiteren Verarbeitung keine neuen Techniken entwickelt werden müssen.

Bei der Verwendung von umhüllten Partikeln in der Elektrodenschicht von Vielschicht-Kaltleitern ist es darüber hinaus vorteilhaft, wenn die Elektrodenschicht neben den Partikeln noch ein Edelmetall wie Silber oder Palladium enthält, so daß auch bei partieller Oxidation der für den Sperrschichtabbau verantwortlichen Elektrodenkomponenten im Kern der Partikel eine hohe Leitfähigkeit innerhalb der Elektrodenschicht gewährleistet ist. Eine Elektrodenschicht eines Vielschicht-Kaltleiters kann z.B. zu 10 Gew.-% aus beschichtetem Wolfram-Pulver und zu 90 Gew.-% aus einer Mischung aus Silber und Palladium bestehen.

Des weiteren kann die Schutzschicht wenigstens zwei Teilschichten aufweisen, die unterschiedliche Materialien enthalten. Beispielsweise kommt es in Betracht, ein Pulver für die Elektrodenschichten zu verwenden, dessen Partikel in ihrem Kern im wesentlichen aus Wolfram bestehen, wobei der Kern der Partikel von einer Silberschicht umhüllt ist. Die silberhaltige Umhüllung wiederum ist von einer zweiten Hülle umhüllt, die Platin enthält. Eine solche als Doppelschicht ausgeführte Schutzschicht hat den Vorteil, daß sich während des Aufheizprozesses beim Sintern des Bauelements aus dem Silber und dem Platin eine Legierung bilden kann, die bei einer höheren Temperatur als Silber (Silber schmilzt bei ca. 960 °C) schmilzt, wodurch ein teilweiser Schutzschichtabbau verhindert werden kann. Die Schutzschicht erlaubt dadurch nicht den Zutritt von zuviel Sauerstoff zum Wolfram im Kern des Partikels.

Ein für den Einsatz in dem erfindungsgemäßen Vielschichtbauelement geeignetes Pulver kann beispielsweise durch Umhüllen von Partikeln eines geeigneten Metalls mit einer Edelmetallschicht mittels eines physikalischen Verfahrens hergestellt werden. Als physikalisches Verfahren zur Herstellung von Pulvern, deren Partikel umhüllt sind, kommen beispielsweise Sputtern oder auch Aufdampfen in Betracht. Dabei muß jedoch beachtet werden, daß die Partikel des Pulvers während des Aufdampfens bzw. Sputterns bewegt werden müssen, so daß sie allseitig beschichtet werden.

Bor- oder siliziumhaltige Gläser als Schutzmaterial können in Form einer Schutzschicht durch chemische Verfahren wie PVD oder CVD auf ein Pulver aufgebracht werden.

Bei Anwendungen des erfindungsgemäßen Vielschichtbauelements als Piezoaktor oder auch als Kondensator ist es vorteilhaft, wenn die Schutzschicht den Körper dicht umschließt. In diesen Fällen ist eine Oxidation des Körpers unerwünscht. Durch ein dichtes Umschließen des Körpers mit der Schutzschicht kann das Herantreten von Sauerstoff, abgesehen von Sauerstofftransport mittels Diffusion, weitgehend vermindert werden.

Bei den genannten Verfahren zur Herstellung von Pulvern, deren Partikel umhüllt sind, entstehen Schutzschichten, die Poren aufweisen. Diese Poren können in vorteilhafter Weise den Zutritt von Sauerstoff zum Kern der Partikel erlauben und dadurch dem Sperrschichtabbau in den Vielschicht-Kaltleitern dienen. Um jedoch andererseits den Zutritt von zuviel Sauerstoff zum Körper zu verhindern, kann es vorteilhaft sein, die Schichtdicke der Schutzschicht so zu wählen, daß die Anzahl der Poren reduziert ist und somit der Zutritt von Sauerstoff auf das für den Sperrschichtabbau erforderliche Maß reduziert ist. Eine geeignete Dicke für die Schutzschicht beträgt auch im Hinblick auf ein zu verwendendes Siebdruckverfahren weniger als 5 µm.

Des weiteren ist es vorteilhaft, wenn die in dem Pulver, das in einer Paste zur Herstellung der Elektrodenschichten verwendet wird, enthaltenen Partikel eine Ausdehnung von typischerweise <5 µm aufweisen. Gleichzeitig ist es vorteilhaft, wenn die Schutzschicht eine Dicke von ebenfalls typischerweise <5 µm aufweist. Solche Partikelabmessungen haben den Vorteil, daß die üblichen Siebe für das Siebdruckverfahren zum Auftragen von Elektrodenschichten auf keramische Grünfolien verwendet werden können. Die üblichen Siebe haben typischerweise eine Maschenweite kleiner als 5µm.

Es sind aber auch andere Größenverhältnisse zwischen Partikel und Schutzschicht denkbar.

Des weiteren gibt die Erfindung ein Verfahren zur Herstellung eines elektrischen Vielschichtbauelements an, wobei die Sinterung der Schichten bei einer Temperatur von typischerweise oberhalb 800°C durchgeführt wird.

Ein solches Verfahren hat den Vorteil, daß die für viele Anwendungen bzw. Keramikmaterialien benötigten Sintertemperaturen erreicht werden können. Darüber hinaus kommen aufgrund der erfindungsgemäßen Schutzschicht für das Metall des Körpers preiswerte Metalle in Betracht.

Darüber hinaus ist ein Verfahren zur Herstellung eines Vielschichtbauelements vorteilhaft, wobei die Sinterung des Schichtstapels in einer Atmosphäre erfolgt, bei der der Sauerstoff-Gleichgewichtspartialdruck des Gleichgewichts Körpermetall/Körpermetalloxid überschritten ist. Ein solches Verfahren hat den Vorteil, daß mit erhöhtem Sauerstoffdruck, beispielsweise mit Luft, beim Sintern gearbeitet werden kann, wodurch die Prozeßführung zur Herstellung des Bauelements entscheidend vereinfacht wird. Beispielsweise kann bei Verwendung von Wolfram als Metall für den Körper bei einer Sauerstoffatmosphäre gearbeitet werden, welche den Gleichgewichtspartialdruck Wolfram/Wolframdioxid überschreitet.

Dadurch kann der für viele Keramiken erforderliche hohe Sauerstoffanteil der Sinteratmosphäre zugeführt werden, wobei die Schutzschicht das unedle Metall, beispielsweise Wolfram, wirksam vor dem hohen Sauerstoffpartialdruck schützt.

Im folgenden wird die Erfindung anhand von Ausführungsbeispielen und den dazu gehörigen Figuren näher erläutert.
- Figur 1: zeigt beispielhaft ein erfindungsgemäßes Viel- schichtbauelement in perspektivischer Darstellung
- Figur 2A: zeigt den Partikel eines Pulvers, welches zur Her- stellung von Elektrodenschichten in dem erfindungs- gemäßen Bauelement verwendet werden kann, im sche- matischen Querschnitt.
- Figur 2B: zeigt einen Partikel gemäß Figur 2A, dessen Schutz- schicht Poren aufweist.
- Figur 3: zeigt beispielhaft den Aufbau einer Elektroden- schicht eines erfindungsgemäßen Bauelements im schematischen Querschnitt.

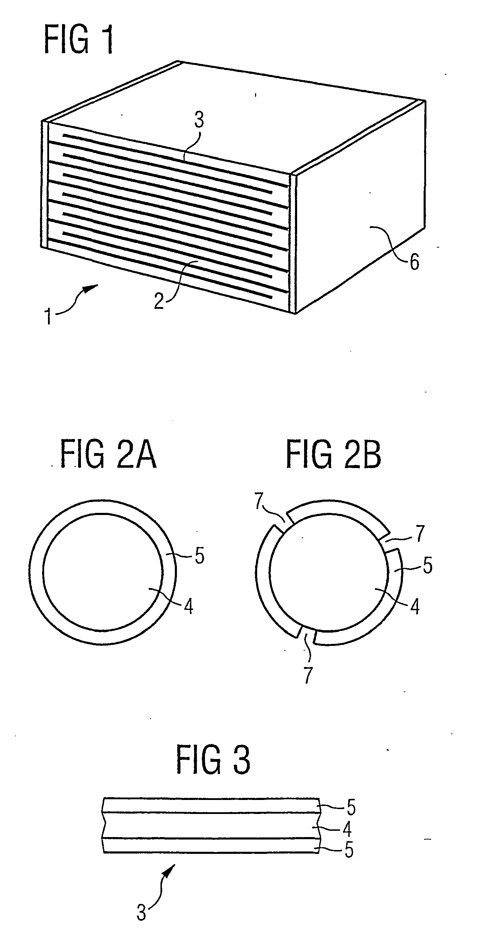

Figur 1 zeigt ein Bauelement in perspektivischer Darstellung. Es wird hergestellt durch Sintern eines Stapels von übereinanderliegenden Grünfolien und Elektrodenschichten. Auf eine Oberfläche einer Grünfolie wird dazu in dem für die Elektrode vorgesehenen Bereich eine Elektrodenpaste aufgebracht. Dazu eignen sich eine Reihe von insbesondere Dickschichtverfahren, vorzugsweise Aufdrucken, beispielsweise mittels Siebdruck. Zumindest im Bereich einer Kante der Grünfolie oder nur im Bereich einer Ecke der Grünfolie verbleibt ein nicht von Elektrodenpaste bedeckter Oberflächenbereich. Möglich ist es auch, die Elektrode nicht als flächige Schicht aufzubringen, sondern strukturiert, gegebenenfalls als durchbrochenes Muster.

Die Siebdruckpaste besteht z.B. aus metallischen, metallisches Wolfram oder eine Wolframverbindung umfassenden Partikeln zur Herstellung der gewünschten Leitfähigkeit, ggf. sinterfähigen keramischen Partikeln zur Anpassung der Schwundeigenschaften der Elektrodenpaste an die der Keramik und einem ausbrennbaren organischen Binder, um eine Formbarkeit der keramischen Masse bzw. einen Zusammenhalt der Grünkörper zu gewährleisten. Dabei können Partikel aus reinem Wolfram, Partikel aus Wolframlegierung, Wolframverbindung oder gemischte Partikel aus Wolfram und anderen Metallen verwendet werden. Die Partikel sind dabei von einer erfindungsgemäßen Schutzschicht umhüllt (vergleiche Figur 2A und B). Bei keramischen Vielschichtbauelementen, die einer nur geringen mechanischen Belastung ausgesetzt sind, ist es auch möglich, in der Elektrodenpaste auf die keramischen Anteile ganz zu verzichten.

Anschließend werden die bedruckten Grünfolien in einer gewünschten Anzahl so zu einem Folienstapel übereinandergeschichtet, daß (grüne) Keramikschichten und Elektrodenschichten alternierend übereinander angeordnet sind.

Anschließend wird der auf Grund des Binders noch formelastische Folienstapel durch Pressen und gegebenenfalls Zuschneiden in die gewünschte äußere Form gebracht. Dann wird die Keramik gesintert, was einen mehrstufigen Prozeß umfassen kann. Die endgültige Sinterung, bei der die Keramik bis zu vollständigen bzw. bis zur gewünschten Verdichtung zusammensintert, liegt in der Regel zwischen 800 und 1500°C.

Nach der Sinterung entsteht aus den einzelnen Grünfolienschichten ein monolithischer keramischer Schichtstapel 1, der einen festen Verbund der einzelnen von Keramikschichten gebildeten Dielektrikumschichten 2 aufweist. Dieser feste Verbund ist auch an den Verbindungsstellen Keramik/Elektrode/Keramik gegeben. Im Schichtstapel 1 sind alternierend Dielektrikumschichten 2 und Elektrodenschichten 3 übereinander angeordnet. An zwei einander gegenüberliegenden Seiten des Bauelementkörpers werden nun Außenelektroden 6 erzeugt, die jeweils mit jeder zweiten Elektrodenschicht 3 in elektrischem Kontakt stehen. Dazu kann beispielsweise zunächst eine Metallisierung, üblicherweise aus Silber auf der Keramik erzeugt werden, beispielsweise durch stromlose Abscheidung. Diese kann anschließend galvanisch verstärkt werden, z.B. durch Aufbringen einer Schichtfolge Ag/Ni/Sn. Dadurch wird die Lötfähigkeit auf Platinen verbessert. Es sind jedoch auch andere Möglichkeiten der Metallisierung beziehungsweise der Erzeugung der Elektrodenschichten 6 geeignet.

Durch die Verwendung von umhüllte Wolframpartikel gemäß Figur 2 enthaltenden Elektrodenschichten in Verbindung mit einer Kaltleiter-Keramik werden folgende Vorteile erreicht:
a Verminderung der Oxidation dadurch Verminderung der Volumenausdehnung
b Verbesserung der Haftfestigkeit zur Keramik
c Verbesserung der elektrischen Leitfähigkeit durch weniger Oxidation
d Bessere Anbindefähigkeit für eine Außenmetallisierung aus einer Silber-Einbrennpaste an Elektrodenschichten
e Die Ladungsverteilung innerhalb der Schicht wird vergleichmäßigt aufgrund einer verbesserten Homogenität durch weniger Oxidation.
f der Sperrschichtabbau wird durch Wolfram in Verbindung mit Kaltleiter-Keramik erreicht Herstellung eines Ohmschen Kontakts

Die Erfindung beschränkt sich aber nicht auf Kaltleiter-Keramiken mit wolframhaltigen Elektrodenschichten, sondern ist vielmehr auch auf andere Arten von elektrokeramischen Bauelementen anwendbar, wie beispielsweise auf Kondensatoren oder Piezobauelemente, bei denen vorzugsweise Perowskitkeramiken Anwendung finden oder auch auf Heißleiter in Verbindung mit Spinell-Keramiken. Darüber hinaus kommen als erfindungsgemäße Bauelemente auch solche in Betracht, bei denen die Keramikschichten eine Zinkoxid-Keramik enthalten und die dadurch als Varistoren geeignet sind. Darüber hinaus kann das erfindungsgemäße Bauelement als Kaltleiter verwendet werden, falls bei den Dielektrikumschichten Bariumtitanat-Keramiken mit den Zusätzen Barium, Titan, Calcium, Strontium oder Blei bzw. weitere Dotierelemente verwendet werden.

Figur 2A zeigt einen Körper 4 in Form eines Partikels, der von einer Schutzschicht 5 umhüllt ist, die den Partikel dicht umschließt. Um für die Anwendung in Vielschicht-Kaltleitern notwendige partielle Oxidation zu erreichen, können poröse Schutzschichten erzeugt bzw. kann die Schichtstärke der Schutzschicht angepaßt werden, die den Zutritt von kleinen Mengen Sauerstoff zum Körper 4 erlaubt. Figur 2B zeigt einen solchen Partikel, dessen Schutzschicht 5 Poren 7 aufweist. Der Körper 4 kann beispielsweise aus Wolfram bestehen, während die Umhüllung 5 aus Palladium als Schutzmaterial besteht.

Figur 3 zeigt eine Elektrodenschicht 3 nach dem Stand der Technik, bei der der Körper 4 die Form einer Schicht aufweist, die an der Ober- und an der Unterseite mit einer Schutzschicht 5 bedeckt ist. Die Schutzschicht 5 kann beispielsweise aus Palladium bestehen, während der Körper 4 Wolfram enthalten kann.

Die Erfindung beschränkt sich nicht auf die dargestellten Ausführungsbeispiele, sondern wird in ihrer allgemeinsten Form durch Patentanspruch 1 definiert.

## Patentansprüche

1. Elektrisches Vielschichtbauelement
- mit einem Schichtstapel (1), der übereinander liegende Dielektrikumschichten (2) und zwischen den Dielektrikumschichten (2) angeordnete elektrisch leitfähige Elektrodenschichten (3) aufweist,
- wobei die Dielektrikumschichten (2) ein keramisches Material umfassen,
- wobei wenigstens eine Elektrodenschicht (3) einen von einer Schutzschicht (5) umhüllten als Partikel ausgebildeten Körper (4) aus unedlem Metall enthält,
- wobei die Schutzschicht (5) ein Schutzmaterial enthält, das die Oxidation des unedlen Metalls verlangsamt.

2. Bauelement nach Anspruch 1,
das durch Gemeinsamsinterung von den als keramische Grünfolien ausgebildeten Dielektrikumschichten (2) und Elektrodenschichten (3) hergestellt ist.

3. Bauelement nach einem der Ansprüche 1 oder 2,
bei dem das Schutzmaterial so gewählt ist, daß es bei der Sinterung bei Temperaturen >800°C die Oxidation des unedlen Metalls verlangsamt.

4. Bauelement nach einem der Ansprüche 1 bis 3,
bei dem das Schutzmaterial ein Edelmetall ist.

5. Bauelement nach einem der Ansprüche 1 bis 4,
bei dem das Metall des Körpers Wolfram, Kupfer, Nickel, Aluminium, Titan oder Chrom ist.

6. Bauelement nach einem der Ansprüche 1 bis 5,
bei dem das Schutzmaterial Gold, Silber, Platin oder Palladium ist.

7. Bauelement nach einem der Ansprüche 1 bis 6,
bei dem der ohmsche Widerstand der Dielektrikumschichten (2) einen positiven Temperaturkoeffizienten aufweist.

8. Bauelement nach einem der Ansprüche 1 bis 7,
bei dem die Elektrodenschichten (3) Wolframkarbid oder Wolframnitrid enthalten.

9. Bauelement nach einem der Ansprüche 1 bis 8,
bei dem der Körper (4) eine Schicht ist, die auf wenigstens einer Seite mit einer Schutzschicht (5) bedeckt ist.

10. Bauelement nach einem der Ansprüche 1 bis 9,
bei dem die Schutzschicht (5) wenigstens zwei Teilschichten aufweist, die unterschiedliche Materialien enthalten.

11. Bauelement nach einem der Ansprüche 1 bis 10,
bei dem die Elektrodenschichten (3) aus einem Pulver hergestellt sind, dessen Partikel jeweils den Körper (4) bilden und durch ein chemisches oder physikalisches Verfahren mit einem Schutzmaterial umhüllt sind.

12. Bauelement nach Anspruch 10 oder 11,
bei dem die Schutzschicht (5) den Körper (4) dicht umschließt.

13. Bauelement nach einem der Ansprüche 1 bis 11,
bei dem die Schutzschicht (5) Poren (7) aufweist.

14. Bauelement nach einem der Ansprüche 1 bis 13,
bei dem der Partikel eine Ausdehnung von maximal 5 µm aufweist und bei dem die Schutzschicht (5) eine Dicke von maximal 5 µm aufweist.

15. Bauelement nach einem der Ansprüche 1 bis 14,
bei dem an Außenflächen des Schichtstapels (1) Außenelektroden (6) angeordnet sind, die mit Elektrodenschichten (3) kontaktiert sind.

16. Bauelement nach Anspruch 15,
bei dem benachbarte Elektrodenschichten (3) mit verschiedenen Außenelektroden (6) kontaktiert sind.

17. Verfahren zur Herstellung eines elektrischen Vielschichtbauelements nach einem der Ansprüche 2 bis 16,
wobei die Sinterung der Grünfolien und Elektrodenschichten (3) bei einer Temperatur > 800°C durchgeführt wird.

18. Verfahren nach Anspruch 17,
wobei die Sinterung in einer Sauerstoffatmosphäre erfolgt, bei der der Sauerstoff-Gleichgewichtspartialdruck des Gleichgewichtes Metall/Metalloxid überschritten ist.

## Claims

1. Electrical multilayer component
- comprising a layer stack (1) having dielectric layers (2) lying one above another and electrically conductive electrode layers (3) arranged between the dielectric layers (2),
- wherein the dielectric layers (2) comprise a ceramic material,
- wherein at least one electrode layer (3) contains a body (4) composed of base metal, said body being embodied as particles and enveloped by a protective layer (5),
- wherein the protective layer (5) contains a protective material that slows down the oxidation of the base metal.

2. Component according to Claim 1,
which is produced by joint sintering of the dielectric layers (2), embodied as ceramic green sheets, and electrode layers (3).

3. Component according to either of Claims 1 and 2,
wherein the protective material is chosen such that it slows down the oxidation of the base metal during the sintering at temperatures >800°C.

4. Component according to any of Claims 1 to 3,
wherein the protective material is a noble metal.

5. Component according to any of Claims 1 to 4,
wherein the metal of the body is tungsten, copper, nickel, aluminium, titanium or chromium.

6. Component according to any of Claims 1 to 5,
wherein the protective material is gold, silver, platinum or palladium.

7. Component according to any of Claims 1 to 6,
wherein the ohmic resistance of the dielectric layers (2) has a positive temperature coefficient.

8. Component according to any of Claims 1 to 7,
wherein the electrode layers (3) contain tungsten carbide or tungsten nitride.

9. Component according to any of Claims 1 to 8,
wherein the body (4) is a layer covered with a protective layer (5) on at least one side.

10. Component according to any of Claims 1 to 9,
wherein the protective layer (5) has at least two partial layers containing different materials.

11. Component according to any of Claims 1 to 10,
wherein the electrode layers (3) are produced from a powder whose particles in each case form the body (4) and are enveloped with a protective material by a chemical or physical method.

12. Component according to Claims 10 or 11, wherein the protective layer (5) tightly encloses the body (4).

13. Component according to any of Claims 1 to 11,
wherein the protective layer (5) has pores (7).

14. Component according to any of Claims 1 to 13,
wherein the particle has an extent of at most 5 µm, and wherein the protective layer (5) has a thickness of at most 5 µm.

15. Component according to any of Claims 1 to 14,
wherein external electrodes (6) are arranged at outer areas of the layer stack (1), said external electrodes being contact-connected to electrode layers (3).

16. Component according to Claim 15,
wherein adjacent electrode layers (3) are contact-connected to different external electrodes (6).

17. Method for producing an electrical multilayer component according to any of Claims 2 to 16,
wherein the sintering of the green sheets and electrode layers (3) is carried out at a temperature >800°C.

18. Method according to Claim 17,
wherein the sintering is effected in an oxygen atmosphere in which the oxygen equilibrium partial pressure of the metal/metal oxide equilibrium is exceeded.

## Revendications

1. Composant électrique à plusieurs couches, comprenant
- une pile (1) de couches qui a des couches (2) diélectriques superposées et des couches (3) d'électrode conductrices de l'électricité et disposées entre les couches (2) diélectriques,
- dans lequel les couches (2) diélectriques comprennent un matériau céramique,
- dans lequel au moins une couche (3) d'électrode contient un corps (4) en métal commun, constitué sous la forme de particules enrobées d'une couche (5) de protection,
- dans lequel la couche (5) de protection contient un matériau de protection, qui ralentit l'oxydation du métal commun.

2. Composant suivant la revendication 1,
qui est fabriqué par frittage conjoint des couches (3) d'électrode et des couches (2) diélectriques constituées sous la forme de feuilles crues en céramique.

3. Composant suivant l'une des revendications 1 ou 2,
dans lequel le matériau de protection est choisi de manière à ralentir l'oxydation du métal commun lors du frittage à des températures supérieures à 800°C.

4. Composant suivant l'une des revendications 1 à 3,
dans lequel le matériau de protection est un métal noble.

5. Composant suivant l'une des revendications 1 à 4,
dans lequel le métal du corps est le tungstène, le cuivre, le nickel, l'aluminium, le titane ou le chrome.

6. Composant suivant l'une des revendications 1 à 5,
dans lequel le matériau de protection est l'or, l'argent, la platine ou le palladium.

7. Composant suivant l'une des revendications 1 à 6,
dans lequel la résistance ohmique des couches (2) diélectriques a un coefficient de température positif.

8. Composant suivant l'une des revendications 1 à 7,
dans lequel les couches (3) d'électrode contiennent du carbure de tungstène ou du nitrure de tungstène.

9. Composant suivant l'une des revendications 1 à 8,
dans lequel le corps (4) est une couche qui est revêtue d'une couche (5) de protection au moins sur une face.

10. Composant suivant l'une des revendications 1 à 9,
dans lequel la couche (5) de protection a au moins deux couches partielles qui contiennent des matériaux différents.

11. Composant suivant l'une des revendications 1 à 10,
dans lequel les couches (3) d'électrode sont fabriquées à partir d'une poudre dont les particules forment respectivement le corps (4) et sont enrobées d'un matériau de protection par un procédé chimique ou physique.

12. Composant suivant la revendication 10 ou 11,
dans lequel la couche (5) de protection entoure de manière étanche le corps (4).

13. Composant suivant l'une des revendications 1 à 11,
dans lequel la couche (5) de protection a des pores (7).

14. Composant suivant l'une des revendications 1 à 13,
dans lequel la particule a une étendue de 5 µm au maximum et dans lequel la couche (5) de protection a une épaisseur de 5 µm au maximum.

15. Composant suivant l'une des revendications 1 à 14,
dans lequel sur les surfaces extérieures de la pile (1) de couches sont disposées des électrodes (6) extérieures qui sont mises en contact avec des couches (3) d'électrode.

16. Composant suivant la revendication 15,
dans lequel des couches (3) d'électrode voisines sont mises en contact avec diverses électrodes (6) extérieures.

17. Procédé de fabrication d'un composant électrique à plusieurs couches suivant l'une des revendications 2 à 16,
dans lequel on effectue le frittage des feuilles crues et des couches (3) d'électrode à une température supérieure à 800°C.

18. Procédé suivant la revendication 17,
dans lequel on effectue le frittage dans une atmosphère d'oxygène, la pression partielle d'équilibre d'oxygène de l'équilibre métal/oxyde métallique étant dépassée.
